# EUROPÄISCHE PATENTSCHRIFT

(11) **EP 0 486 538 B1**
(45) Veröffentlichungstag und Bekanntmachung des Hinweises auf die Patenterteilung: **02.11.1994**
(21) Anmeldenummer: 90911753.3
(22) Anmeldetag: 11.07.1990
(51) Int. Cl.: H03G 3/20, G11B 7/09

(54) **SCHALTUNGSANORDNUNG ZUR AUTOMATISCHEN VERSTÄRKUNGSREGELUNG**
CIRCUIT ARRANGEMENT FOR AUTOMATIC GAIN CONTROL
CIRCUIT POUR COMMANDE AUTOMATIQUE DE GAIN

(30) Priorität: 09.08.1989 DE 3926272
(43) Veröffentlichungstag der Anmeldung: 27.05.1992
(73) Patentinhaber: Deutsche Thomson-Brandt GmbH, 78003 Villingen-Schwenningen (DE)
(72) Erfinder: ZUCKER, Friedhelm, D-7733 Mönchweiler (DE)
(86) Internationale Anmeldenummer: EP9001127
(87) Internationale Veröffentlichungsnummer: WO9102406

(56) Entgegenhaltungen:
- EP-A- 0 237 682
- US-A- 4 835 755
- PATENT ABSTRACTS OF JAPAN, Bd. 12, Nr. 408 (P-778), 28. Jan. 1988 & JP-A-63-146232
- PATENT ABSTRACTS OF JAPAN, Bd. 6, Nr. 81 (E-107)(959), 19. Mai 1982 & JP-A-57-17213
- PATENT ABSTRACTS OF JAPAN, Bd. 11, Nr. 383 (P-646), 15. Dez. 1987 & JP-A-62-149069
- PATENT ABSTRACTS OF JAPAN, Bd. 7, Nr. 236 (E-205)(1381), 20. Okt. 1983 & JP-A-58-124310

## Beschreibung

Die Erfindung betrifft eine Schaltungsanordnung zur automatischen Verstärkungsregelung.

Automatische Verstärkungsregelung, häufig mit AGC abgekürzt, wird z.B. in Funkempfängern angewendet, um den maximalen Ausgangspegel unabhängig von Schwankungen der Empfangsfeldstärke auf einen konstanten Wert zu regeln.

In einem CD-Spieler oder einem magneto-optischen Aufzeichnungs- und Wiedergabegerät strahlt ein Laserstrahl auf einen optischen Aufzeichnungsträger, der den Laserstrahl auf einen Photodetektor aus mehreren Photodioden reflektiert. Aus den Ausgangssignalen der Photodioden werden neben dem Datensignal ein Fokusfehlersignal für den Fokusregelkreis und ein Spurfehlersignal für den Spurregelkreis erzeugt.

Wenn sich die Laserleistung oder das Reflexionsvermögen des optischen Aufzeichnungsträgers verändern, so wird dadurch auch die Schleifenverstärkung des Fokus- und des Spurregelkreises verändert.

In einem optischen Wiedergabegerät, das in der US-A-4 835 755 beschrieben ist, werden das analoge Fokusfehlersignal, das analoge Spurfehlersignal sowie das analoge Regelsignal zur Regelung der Drehzahl des Plattenantriebsmotors mittels mehrerer Analog-Digital-Wandler in digitale Signale umgewandelt, die in einem Mikroprozessor ausgewertet werden. Der Mikroprozessor gibt digitale Regelsignale ab, die mittels Digital-Analog-Wandler wieder in analoge Regelsignale für die Stellglieder des Fokus- und des Spurregelkreises sowie für den Plattenantriebsmotor gewandelt werden.

Eine bekannte Lösung, die Schleifenverstärkung auf einen konstanten Wert zu regeln, die in dem Baustein AD 533 von Analog Devices verwirklicht ist, sieht eine analoge Dividierschaltung vor, in der das Fokusfehlersignal und das Spurfehlersignal durch einen Wert geteilt werden, welcher zur gesamten auf den Photodetektor einfallenden Lichtenergie proportional ist. Das Fokusfehler- und das Spurfehlersignal werden daher auf die gesamte einfallende Lichtenergie bezogen normiert. Diese bekannte Lösung weist aber zwei erhebliche Nachteile auf, denn die analoge Dividierschaltung ist relativ teuer und erfordert einen sehr aufwendigen Abgleich.

Es ist daher Aufgabe der Erfindung, eine Schaltungsanordnung zur automatischen Verstärkungsregelung so zu gestalten, daß sie einfach herstellbar ist und keinen Abgleich mehr erfordert.

Die Erfindung löst diese Aufgabe dadurch, daß das zu verstärkende Eingangssignal über einen steuerbaren Schalter und einen ersten Tiefpaß einem Verstärker sowie über einen zweiten Tiefpaß und den Analog-Digital-Wandler dem Mikroprozessor zugeführt wird, daß der Ausgang des Mikroprozessors mit dem Eingang eines Pulsweitenmodulators verbunden ist, dessen Ausgang mit dem Steuereingang des steuerbaren Schalters verbunden ist, und daß der Mikroprozessor in Abhängigkeit von den digitalen Werten am Ausgang des Analog-Digital-Wandlers ein Steuersignal für den Pulsweitenmodulator erzeugt.

Es zeigen
Figur 1 ein Ausführungsbeispiel der Erfindung
Figur 2 und 3 ein Anwendungsbeispiel der Erfindung.

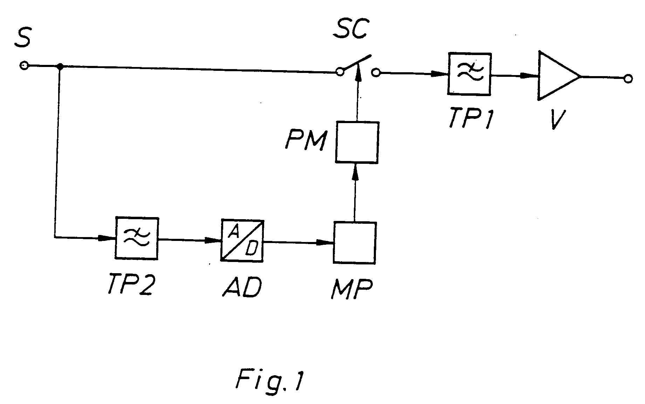

Anhand der Figur 1 wird die Erfindung nun beschrieben und anschließend erläutert.

Das in einem Verstärker V zu verstärkende Signal S liegt am Eingang eines steuerbaren Schalters SC, dessen Ausgang über einen Tiefpass TP1 mit dem Eingang des Verstärkers V verbunden ist, und am Eingang eines Tiefpasses TP2, dessen Ausgang mit dem Eingang eines Analog-Digital-Wandlers AD verbunden ist. Der Ausgang des Analog-Digital-Wandlers AD ist mit dem Eingang eines Mikroprozessors MP verbunden, dessen Ausgang mit dem Eingang eines Pulsweitenmodulators PM verbunden ist. Der Ausgang des Pulsweitenmodulators PM ist mit dem Steuereingang des steuerbaren Schalters SC verbunden.

Der Mikroprozessor MP erzeugt in Abhängigkeit vom digitalen Wert am Ausgang des Analog-Digital-Wandlers AD z.B. mittels eines Algorithmus ein Steuersignal für den Pulsweitenmodulator PM, der das Tastverhältnis seines Ausgangssignals daher ebenfalls in Abhängigkeit vom digitalen Wert am Ausgang des Analog-Digital-Wandlers AD ändert. Um den maximalen Ausgangspegel des Verstärkers V auf einen konstanten Wert zu regeln, wird das Tastverhältnis, mit dem der steuerbare Schalter SC geöffnet und geschlossen wird, bei steigendem Pegel des Eingangssignals S erniedrigt, bei fallendem Pegel dagegen erhöht. Damit schnelle Pegeländerungen des Eingangssignals S aber nicht ausgeregelt werden, was unabhängig vom Pegel des Eingangssignals S zu einem stets konstanten Ausgangspegel des Verstärkers V führen würde, ist dem Analog-Digital-Wandler AD ein Tiefpass TP1 vorgeschaltet. Ein weiterer Tiefpass TP2 ist zwischen dem steuerbaren Schalter SC und dem Verstärker V vorgesehen, um die Schaltfrequenz des steuerbaren Schalters SC und deren Seitenbänder zu unterdrücken.

Der steuerbare Schalter SC, für den ein schneller Analogschalter besonders gut geeignet ist, wirkt mit dem nachfolgenden Tiefpass TP1 wie ein elektronisch gesteuertes Potentiometer. Besonders vorteilhaft ist es, die Schaltfrequenz am Ausgang des Pulsweitenmodulators PM sehr hoch zu wählen.

Der Mikroprozessor MP kann das Steuersignal für den Pulsweitenmodulator PM z.B. auch aus den Werten einer Tabelle erzeugen, die in einem Speicher gespeichert sind. Jedem digitalen Wert am Ausgang des Analog-Digital-Wandlers AD ist ein Wert im Speicher zugeordnet. Die einzelnen Werte im Speicher können z.B. das Tastverhältnis des Signals des Pulsweitenmodulators PM bestimmen. So ist jedem digitalen Wert am Ausgang des Analog-Digital-Wandlers AD ein bestimmtes Tastverhältnis zugeordnet.

Die erfindungsgemäße automatische Verstärkungsregelung ist z.B. für den Spur- und den Fokusregelkreis eines CD-Spielers oder eines magneto-optischen Aufnahme- und Wiedergabegerätes geeignet.

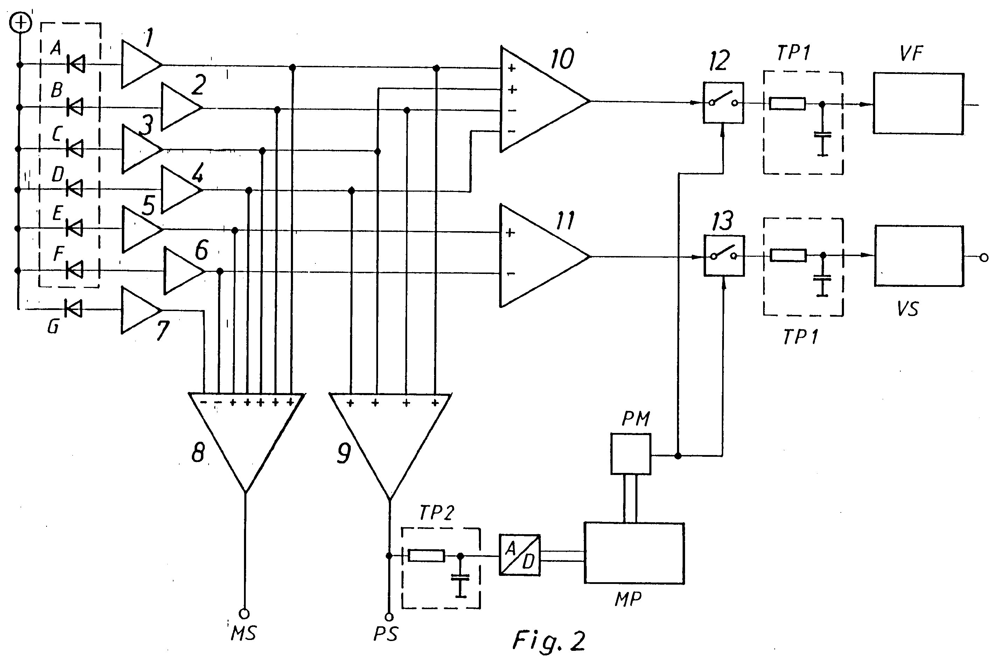

In der Figur 2 ist dieser Anwendungsfall gezeigt. Das magneto-optische Aufzeichnungs- und Wiedergabegerät kann gleichzeitig Daten von einem Aufzeichnungsträger lesen, die sowohl mittels Pits als auch in einer magneto-optischen Schicht des Aufzeichnungsträgers aufgezeichnet sind. Die optische Abtastvorrichtung eines derartigen magneto-optischen Aufzeichnungs- und Wiedergabegerätes ist aus der DE-OS 37 32 874 bekannt; der zugehörige Aufzeichnungsträger, auf dem sowohl Daten mittels Pits als auch in einer magneto-optischen Schicht gespeichert sind, ist in der DE-OS 37 32 875 beschrieben.

Das von einem Laser ausgestrahlte Licht wird vom magneto-optischen Aufzeichnungsträger in bekannter Weise auf einen Vierquadrantenphotodetektor mit vier Photodioden A, B, C und D sowie auf je eine rechts und links neben dem Vierquadrantendetektor liegende Photodiode E und F reflektiert. Außerdem reflektiert der Aufzeichnungsträger das vom Laser ausgestrahlte Licht noch auf eine Photodiode G. Die Ausgangsströme der Photodioden A - G werden mittels Strom-Spannungs-Wandlern 1 - 7 in Spannungen AS - GS umgewandelt. Mittels eines Addierers und Subtrahierers 8 wird das Datensignal MS = AS + BS + CS + DS - ES - FS - GS gebildet, das die in der magneto-optischen Schicht des Aufzeichnungsträgers gespeicherten Daten enthält.

Das Datensignal PS, das die mittels der Pits gespeicherten Daten enthält, wird in einem Addierer 9 gebildet: PS = AS + BS + CS + DS. Das Fokusfehlersignal FE = AS + CS - BS - DS wird in einem Addierer und Subtrahierer 10 erzeugt. Ein Differenzverstärker 11 erzeugt das Spurfehlersignal TE = ES - FS . Der Ausgang des Addierers und Subtrahierers 10 ist über einen steuerbaren Schalter 12 und einen Tiefpass 14, der als RC-Glied ausgeführt ist, mit dem Regelverstärker 16 des Fokusregelkreises verbunden. Der Ausgang des Differenzverstärkers 11 ist über einen steuerbaren Schalter 13 und einen ebenfalls als RC-Glied ausgeführten Tiefpass 15 mit dem Regelverstärker 17 des Spurregelkreises verbunden. Der Ausgang des Addierers 9 ist über einen Tiefpass TP2 mit dem Eingang eines Analog-Digital-Wandlers AD verbunden, dessen Ausgang mit dem Eingang eines Mikroprozessors MP verbunden ist. Der Ausgang des Mikroprozessors MP ist mit dem Eingang eines Pulsweitenmodulators PM verbunden, dessen Ausgang mit den Eingängen der steuerbaren Schalter 12 und 13 verbunden ist.

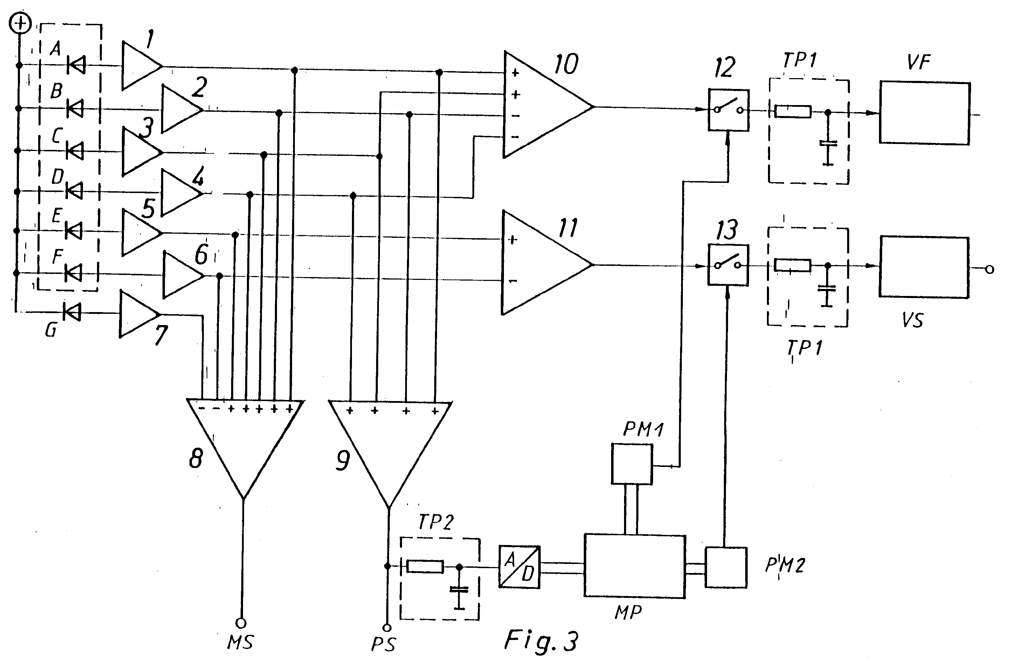

Es ist auch möglich, wie Figur 3 zeigt, sowohl für den Fokusals auch für den Spurregelkreis je einen Pulsweitenmodulator PM1 und PM2 vorzusehen. Der Mikroprozessor MP erzeugt dann ein erstes Steuersignal für den einen Pulsweitenmodulator PM1, dessen Ausgang mit dem Steuereingang des steuerbaren Schalters 12 verbunden ist, und unabhängig davon ein zweites Steuersignal für den anderen Pulsweitenmodulator PM2, dessen Ausgang mit dem Steuereingang des steuerbaren Schalters 13 verbunden ist.

Weil das Summensignal PS = AS + BS + CS + DS ein unmittelbares Maß für die auf den Vierquadrantendetektor strahlende gesamte Lichtenergie darstellt, ist es sinnvoll, aus dem Summensignal PS im Mikroprozessor MP das Regelsignal zur Regelung der Verstärkung zu erzeugen.

Die Erfindung ist jedoch keineswegs auf den in Figur 2 und 3 dargestellten Anwendungsfall beschränkt. Sie ist allgemein für die automatische Verstärkungsregelung geeignet.

## Patentansprüche

1. Schaltungsanordnung zur automatischen Verstärkungsregelung mit einem Analog-Digital-Wandler (AD), dessen Ausgang mit dem Eingang eines Mikroprozessors (MP) verbunden ist, der ein Steuersignal erzeugt, **dadurch gekennzeichnet**, daß das zu verstärkende Eingangssignal (S) über einen steuerbaren Schalter (SC) und einen ersten Tiefpaß (TP1) einem Verstärker (V) sowie über einen zweiten Tiefpaß (TP2) und den Analog-Digital-Wandler (AD) dem Mikroprozessor (MP) zugeführt wird, daß der Ausgang des Mikroprozessors (MP) mit dem Eingang eines Pulsweitenmodulators (PM) verbunden ist, dessen Ausgang mit dem Steuereingang des steuerbaren Schalters (SC) verbunden ist, und daß der Mikroprozessor (MP) in Abhängigkeit von den digitalen Werten am Ausgang des Analog-Digital-Wandlers (AD) ein Steuersignal für den Pulsweitenmodulator (PM) erzeugt.

2. Schaltungsanordnung zur automatischen Verstärkungsregelung nach Anspruch 1, **dadurch gekennzeichnet**, daß für den steuerbaren Schalter (SC) ein Analogschalter vorgesehen ist.

3. Schaltungsanordnung zur automatischen Verstärkungsregelung nach Anspruch 1 oder 2, **dadurch gekennzeichnet**, daß der Mikroprozessor (MP) das Steuersignal für den Pulsweitenmodulator (PM) mittels eines Algorithmus aus dem Ausgangssignal des Analog-Digital-Wandlers (AD) erzeugt.

4. Schaltungsanordnung zur automatischen Verstärkungsregelung nach Anspruch 1 oder 2, **dadurch gekennzeichnet**, daß jedem digitalen Wert am Ausgang des Analog-Digital-Wandlers (AD) ein in einem Speicher gespeicherter Wert zugeordnet ist, daß der Mikroprozessor (MP) den jeweils zum digitalen Wert am Ausgang des Analog-Digital-Wandlers (AD) gehörenden Wert im Speicher abfragt und an seinem Ausgang als Steuersignal an den Pulsweitenmodulator (PM) abgibt.

5. Schaltungsanordnung zur automatischen Verstärkungsregelung nach Anspruch 1, 2, 3 oder 4, **dadurch gekennzeichnet**, daß bei einem optischen oder einem magneto-optischen Wiedergabegerät das aus den Ausgangssignalen mehrerer Photodioden (A, B, C, D) gebildete Summensignal (PS) über den zweiten Tiefpass (TP2) und den Analog-Digital-Wandler (AD) dem Mikroprozessor (MP) zugeführt wird und daß der Ausgang des Pulsweitenmodulators (PM) mit dem Steuereingang des steuerbaren Schalters (12, 13) verbunden ist, der im Fokus- und/oder Spurregelkreis vor dem ersten Tiefpaß (TP1) und dem Regelverstärker (VF, VS) liegt.

6. Schaltungsanordnung zur automatischen Verstärkungsregelung nach Anspruch 1, 2, 3 oder 4, **dadurch gekennzeichnet**, daß bei einem optischen oder magneto-optischen Wiedergabegerät das aus den Ausgangssignalen mehrerer Photodioden (A, B, C, D) gebildete Summensignal (PS) über den zweiten Tiefpaß (TP2) und den Analog-Digital-Wandler (AD) dem Mikroprozessor (MP) zugeführt wird, dessen erster Ausgang mit dem Eingang eines ersten Pulsweitenmodulators (PM1) und dessen zweiter Ausgang mit dem Eingang eines zweiten Pulsweitenmodulators (PM2) verbunden ist, daß der Ausgang des ersten Pulsweitenmodulators (PM1) mit dem Steuereingang des steuerbaren Schalters (12) verbunden ist, der vor dem Regelverstarker (VF) des Fokusregelkreises liegt, und daß der Ausgang des zweiten Pulsweitenmodulators (PM2) mit dem Steuereingang des steuerbaren Schalters (13) verbunden ist, der vor dem Regelverstärker (VS) des Spurregelkreises liegt.

## Claims

1. A circuit arrangement for automatic gain control with an analog-to-digital converter (AD), the output of which is connected to a microprocessor (MP), which generates a control signal, characterised in that the input signal (S) to be amplified is supplied via a controllable switch (SC) and a first low-pass filter (TP1) to an amplifier (V) and via a second low-pass filter (TP2) and the analog-to-digital converter (AD) to the microprocessor (MP), in that the output of the microprocessor (MP) is connected to the input of a pulse-width-modulator (PM), the output of which is connected to the control input of the controllable switch (SC), and in that the microprocessor (MP) generates a control signal for the pulse-width-modulator (PM) in dependence upon the digital values at the output of the analog-to-digital converter (AD).

2. A circuit arrangement for automatic gain control according to claim 1, characterised in that for the controllable switch (SC) there is provided an analog switch.

3. A circuit arrangement for automatic gain control according to claim 1 or 2, characterised in that the microprocessor (MP) generates the control signal for the pulse-width-modulator (PM) by means of an algorithm from the output signal of the analog-to-digital converter (AD).

4. A circuit arrangement for automatic gain control according to claim 1 or 2, characterised in that to each digital value at the output of the analog-to-digital converter (AD) there is assigned a value stored in a memory, in that the microprocessor (MP) monitors the respective value in the memory related to the digital value at the output of the analog-to-digital converter (AD) and delivers it at its output as a control signal to the pulse-width-modulator (PM).

5. A circuit arrangement for automatic gain control according to claim 1,2,3 or 4, characterised in that, in an optical or a magneto-optical reproduction device, the sum signal (PS) formed from the output signals of a plurality of photodiodes (A,B,C,D) is supplied via the second low-pass filter (TP2) and the analog-to-digital converter (AD) to the microprocessor (MP) and in that the output of the pulse-width-modulator (PM) is connected to the control input of the controllable switch (12,13), which is located in the focus- and/or tracking-control circuit ahead of the first low-pass filter (TP1) and the control amplifier (VF,VS).

6. A circuit arrangement for automatic gain control according to claim 1,2,3 or 4, characterised in that, in an optical or a magneto-optical reproduction device, the sum signal (PS) formed from the output signals of a plurality of photodiodes (A,B,C,D) is supplied via the second low-pass filter (TP2) and the analog-to-digital converter (AD) to the microprocessor (MP), the first output of which is connected to the input of a first pulse-width-modulator (PM1) and the second output of which is connected to the input of a second pulse-width-modulator (PM2), in that the output of the first pulse-width-modulator (PM1) is connected to the control input of the controllable switch (12), which is located ahead of the control amplifier (VF) of the focus control circuit, and in that the output of the second pulse-width-modulator (PM2) is connected to the control input of the controllable switch (13), which is located ahead of the control amplifier (VS) of the tracking control circuit.

## Revendications

1. Circuit pour le réglage automatique du gain avec un convertisseur analogique-numérique (AD) dont la sortie est reliée à l'entrée d'un microprocesseur (MP) qui produit un signal de commande, **caractérisé en ce** que le signal d'entrée à amplifier (S) est amené par un commutateur qui peut être commandé (SC) et par un premier passe-bas (TP1) à un amplificateur (V) ainsi que par un second passe-bas (TP2) et par le convertisseur analogique-numérique (AD) au microprocesseur (MP), que la sortie du microprocesseur (MP) est reliée à l'entrée d'un modulateur d'impulsions en largeur (PM) dont la sortie est reliée à l'entrée de commande du commutateur qui peut être commandé (SC) et que le microprocesseur (MP) génère, en fonction des valeurs numériques à la sortie du convertisseur analogique-numérique (AD), un signal de commande pour le modulateur d'impulsions en largeur (PM).

2. Circuit pour le réglage automatique du gain selon la revendication 1, **caractérisé en ce** qu'un commutateur analogique est prévu pour le commutateur qui peut être commandé (SC).

3. Circuit pour le réglage automatique du gain selon la revendication 1 ou 2, **caractérisé en ce** que le microprocesseur (MP) génère le signal de commande pour le modulateur d'impulsions en largeur (PM) au moyen d'un algorithme à partir du signal de sortie du convertisseur analogique-numérique (AD).

4. Circuit pour le réglage automatique du gain selon la revendication 1 ou 2, **caractérisé en ce** qu'une valeur mémorisée dans une mémoire est affectée à chaque valeur numérique à la sortie du convertisseur analogique-numérique (AD), que le microprocesseur (MP) interroge dans la mémoire la valeur qui correspond respectivement à la valeur numérique à la sortie du convertisseur analogique-numérique (AD) et la fournit à sa sortie comme signal de sortie au modulateur d'impulsions en largeur (PM).

5. Circuit pour le réglage automatique du gain selon la revendication 1, 2, 3 ou 4, **caractérisé en ce** que, pour un appareil de reproduction optique ou magnéto-optique, le signal de somme (PS) formé à partir des signaux de sortie de plusieurs photodiodes (A, B, C, D) est amené par le second passe-bas (TP2) et le convertisseur analogique-numérique (AD) au microprocesseur (MP) et que la sortie du modulateur d'impulsions en largeur (PM) est reliée à l'entrée de commande du commutateur qui peut être commandé (12, 13) qui se trouve dans le circuit de réglage de foyer et/ou de piste devant le premier passe-bas (TP1) et l'amplificateur de réglage (VF, VS).

6. Circuit pour le réglage automatique du gain selon la revendication 1, 2, 3 ou 4, **caractérisé en ce** que, pour un appareil de reproduction optique ou magnéto-optique, le signal de somme (PS) formé à partir des signaux de sortie de plusieurs photodiodes (A, B, C, D) est amené par le second passe-bas (TP2) et le convertisseur analogique-numérique (AD) au microprocesseur (MP) dont la première sortie est reliée à l'entrée d'un premier modulateur d'impulsions en largeur (PM1) et dont la seconde sortie est reliée à l'entrée d'un second modulateur d'impulsions en largeur (PM2), que la sortie du premier modulateur d'impulsions en largeur (PM1) est reliée à l'entrée de commande du commutateur qui peut être commandé (12) qui se situe devant l'amplificateur de réglage (VF) du circuit de réglage de foyer et que la sortie du second modulateur d'impulsions en largeur (PM2) est reliée à l'entrée de commande du commutateur qui peut être commandé (13) qui se situe devant l'amplificateur de réglage (VS) du circuit de réglage de piste.
